# EUROPÄISCHE PATENTANMELDUNG

(11) **EP 2 431 948 A1**
(43) Veröffentlichungstag der Anmeldung: **21.03.2012**
(21) Anmeldenummer: 11007524.9
(22) Anmeldetag: 15.09.2011
(51) Int. Cl.: G07C 9/00, B29C 65/16, H05K 5/06

(54) **Steuereinrichtung zur Steuerung, insbesondere zur Übermittlung von Öffnungs- und/oder Schliessbefehlen eines elektronischen Schlosses**

(30) Priorität: 17.09.2010 DE 202010012698 U; 01.10.2010 DE 202010013857 U
(71) Anmelder: BURG-WÄCHTER KG, 58540 Meinerzhagen (DE)
(72) Erfinder:
(74) Vertreter: Stenger, Watzke & Ring

(57) **Zusammenfassung**

Die Erfindung betrifft eine Steuereinrichtung zur Steuerung, insbesondere zur Übermittlung von Öffnungs- und/oder Schließbefehlen, eines elektronischen Schlosses. Zur Erreichung einer verbesserten Dichtwirkung gegenüber Feuchtigkeit wird mit der Erfindung vorgeschlagen eine Steuereinrichtung zur Steuerung, insbesondere zur Übermittlung von Öffnungs- und/oder Schließbefehlen eines elektronischen Schlosses, mit einer in einem Gehäuse angeordneten, mindestens eine Platine aufweisenden Steuerungselektronik, welches Gehäuse aus einem Gehäuseunterteil und einem Deckel besteht, wobei Gehäuseunterteil und Deckel aus Kunststoff ausgebildet sind, und wobei Gehäuseunterteil und Deckel derart wasserdicht miteinander, insbesondere durch Ultraschallverschweißung, verbunden sind, dass das Gehäuseunterteil und der Deckel nicht ohne Zerstörung voneinander lösbar sind.

## Beschreibung

Die Erfindung betrifft eine Steuereinrichtung zur Steuerung, insbesondere zur Übermittlung von Öffnungs- und/oder Schließbefehlen, eines elektronischen Schlosses.

Derartige Steuereinrichtungen an sich sind aus dem Stand der Technik bekannt. Diese umfassen ein aus einem Gehäuseunterteil und einem Deckel gebildetes Gehäuse. Insbesondere kann vorgesehen sein, dass der Deckel eine Tastatur bereitstellt. Hierbei sind insbesondere Steuereinrichtungen mit einem sogenannten Nummernblock zur Eingabe eines PIN-Codes bekannt.

Derartige Steuereinrichtungen sind üblicherweise auch für einen Außeneinsatz vorgesehen. Dabei ist es bekannt, dass die Steuereinrichtung der Witterung, insbesondere Feuchtigkeit, ausgesetzt ist.

Die aus dem Stand der Technik bekannten Maßnahmen zum Schutz der Steuereinrichtung betreffen insbesondere die Verbindung zwischen Deckel und Gehäuseunterteil. Als Verbindungsmittel sind hierbei beispielsweise Verschraubungen, Verrastungen oder dergleichen bekannt. Zur Abdichtung der Steuereinrichtung ist es somit einerseits erforderlich zwischen Deckel und Gehäuseunterteil abzudichten, und andererseits ein Eindringen von Feuchtigkeit an den Verbindungsmitteln, insbesondere bei Schrauben, zu verhindern.

Weitere Maßnahmen zur Erreichung einer Abdichtung der Steuereinrichtung betreffen die Tastatur. Der Stand der Technik schlägt dabei insbesondere solche Tastauren vor, die aus einer flexiblen Membran, beispielsweise aus Gummi, Silikon oder dergleichen gebildet sind. Mittels derartiger flexibler Tastaturen können geschützt dahinter liegende Schalter betätigt werden.

Wenngleich sich die aus dem Stand der Technik bekannten Steuereinrichtungen im alltäglichen Praxiseinsatz bewährt haben, so besteht Verbesserungsbedarf. Zum einen ist das Abdichten zwischen Deckel und Gehäuseunterteil aufwendig, insbesondere wenn Befestigungsmittel wie beispielsweise Schrauben, vorgesehen sind. Zum anderen sind die bekannten Maßnahmen zur Dichtung durch eine geringe Standfestigkeit gekennzeichnet. Insbesondere die für die Tastaturen eingesetzten Membranen aus Gummi oder Silikon verspröden im Laufe der Zeit. Es kommt zu Beschädigungen der Membran, und in der Folge dringt Feuchtigkeit in die Steuereinrichtung ein.

Es ist daher die **Aufgabe** der vorliegenden Erfindung, eine Steuereinrichtung zur Steuerung, insbesondere zur Übermittlung von Öffnungs- und/oder Schließbefehlen eines elektronischen Schlosses vorzuschlagen, welche eine verbesserte Dichtwirkung gegenüber Feuchtigkeit aufweist.

Zur **Lösung** der Aufgabe wird mit der Erfindung vorgeschlagen, eine Steuereinrichtung zur Steuerung, insbesondere zur Übermittlung von Öffnungs- und/oder Schließbefehlen eines elektronischen Schlosses, mit einer in einem Gehäuse angeordneten, mindestens eine Platine aufweisenden Steuerungselektronik, welches Gehäuse aus einem Gehäuseunterteil und einem Deckel besteht, wobei Gehäuseunterteil und Deckel aus Kunststoff ausgebildet sind, und wobei Gehäuseunterteil und Deckel derart wasserdicht miteinander, insbesondere durch Ultraschallverschweißung, verbunden sind, dass das Gehäuseunterteil und der Deckel nicht ohne Zerstörung voneinander lösbar sind.

Der Kern der Erfindung besteht somit darin, dass die Steuereinrichtung wasserdicht ausgebildet ist. Dies wird insbesondere dadurch erreicht, dass Gehäuseunterteil und Deckel wasserdicht miteinander verbunden sind, wobei insbesondere eine Klebverbindung, besonders bevorzugt eine Ultraschallverschweißung vorgesehen ist. Versuche der Anmelderin haben dabei gezeigt, dass Gehäuseunterteil und Deckel, welche aus Kunststoff ausgebildet sind, eine besonders standfeste wasserdichte Verbindung ausbilden, wenn diese durch Ultraschallverschweißung miteinander verbunden sind.

Wasserdicht im Sinne der Erfindung bedeutet, dass das Eindringen von Niederschlag bei einer Outdoor-Anwendung ebenso verhindert wird, wie der Zutritt von Feuchtigkeit in einem Maße, dass elektrische Kontakte korrosionsgefährdet sind beziehungsweise durch Feuchtigkeit verursachte Kriechströme entstehen. In der Regel ist eine solche Wasserdichtigkeit erreicht, wenn das Gehäuse analog zur EN 343; 2003 (wasserdichte Schutzkleidung) dem Wasserdruck einer Wassersäule von zumindest 4m, insbesondere 30m, vorzugsweise 50m widersteht. Wasserdicht im Sinne der Erfindung meint ferner eine solche Wasserdichtigkeit, die mit Schutzartenklasse IPX5 (EN 60529) erreicht wird (Schutz gegen Strahlwasser (Düse) aus beliebigem Winkel). Die erfindungsgemäße Steuereinrichtung genügt ferner der Schutzart IP65 (EN 60529), und ist somit geschützt gegen den Zugang mit einem Draht und staubdicht.

Gleichzeitig soll mit der Erfindung aber auch sichergestellt werden, dass im Gehäuse befindliche Feuchtigkeit aus diesem herausdiffundieren kann.

Das Gehäuseunterteil, welches aus Kunststoff ausgebildet ist, kann insbesondere durch ein Spritzgussverfahren hergestellt sein. Der Deckel, welcher ebenfalls aus Kunststoff ausgebildet ist, kann ebenfalls durch ein Spitzgussverfahren hergestellt sein. Das aus Gehäuseunterteil und Deckel gebildete Gehäuse weist im Längsschnitt in Richtung der Flächennormalen eine trapezförmige Ausbildung auf. Die durch den Deckel gebildete Fläche und die durch den Gehäuseboden gebildete Fläche sind antiparallel zueinander.

Erfindungsgemäß kommt es darauf an, dass das Gehäuseunterteil und der Deckel nicht ohne Zerstörung des Gehäuseunterteils, des Deckels und/oder eines anderen, die wasserdichte Verbindung zwischen Gehäuseunterteil und Deckel bewirkenden Mittels voneinander lösbar sind. Das die wasserdichte Verbindung zwischen Gehäuseunterteil und Deckel bewirkende Mittel kann ein kraft- und/oder formschlüssiges Mittel, beispielsweise ein Klebstoff, eine das Gehäuseunterteil und den Deckel verbindende Manschette und/oder dergleichen, sein. Nicht ohne Zerstörung voneinander lösbar im Sinne der Erfindung meint, dass das Gehäuseunterteil und der Deckel nicht ohne weiteres, insbesondere nicht mit einem haushaltsüblichen Werkzeug oder gänzlich ohne Werkzeug, voneinander lösbar sind, ohne dass der Versuch des Lösens an der Steuereinrichtung dauerhaft sichtbar wäre. In vorteilhafter Weise wird mit der Erfindung eine der Schutzart IP65 genügende und gleichzeitig besonders einbruchsichere Steuereinrichtung geschaffen.

Gemäß einer vorteilhaften Weiterbildung der Erfindung weist das Gehäuse eine Ausnehmung, insbesondere eine Öffnung auf, durch welche eine in dem Gehäuse angeordnete Energiequelle zugänglich ist, wobei die Ausnehmung, insbesondere die Öffnung, mittels eines Verschlusselements gegen das Eindringen von Feuchtigkeit, insbesondere Regenwasser, abgedichtet ist.

Die Energiequelle kann dabei durch eine Batterie, einen Akkumulator, ein Netzteil oder dergleichen gebildet sein. Weiterhin können Anschlussmöglichkeiten vorgesehen sein, insbesondere zum Anschluss eines Ladekabels zum Aufladen eines Akkumulators. Die Energiequelle kann dabei innerhalb des Gehäuses angeordnet sein, wobei diese mittels einer Öffnung zugänglich ist. Die Energiequelle kann jedoch auch in einer Ausnehmung in dem Gehäuse angeordnet sein, wobei geeignete Anschlussmöglichkeiten zur elektrischen Verbindung mit dem Gehäuseinneren, insbesondere der Steuerungselektronik, bereitgestellt sind.

Wesentlich für diese Weiterbildung ist, dass die Ausnehmung, insbesondere die Öffnung mittels eines Verschlusselements gegen das Eindringen von Feuchtigkeit, insbesondere Regenwasser abgedichtet ist. Das Verschlusselement kann dabei durch einen Gehäusedeckel, eine Kappe, eine Klappe oder dergleichen gebildet sein. Ferner ist vorgesehen, dass zwischen Verschlusselement und Gehäuse eine Dichtung angeordnet ist. Die Dichtung ist insbesondere umlaufend auf dem Verschlusselement angeordnet, so dass dieses gegenüber der im Gehäuse vorgesehenen Ausnehmung, insbesondere Öffnung, wasserdicht abgedichtet ist. Das Verschlusselement kann geeignete Greifmittel aufweisen, insbesondere einen umlaufenden, angefasten Flansch, so dass das Verschlusselement von einem Benutzer sicher zu greifen ist. Weiterhin kann vorgesehen sein, dass das Verschlusselement einen umlaufenden Kragen aufweist, der für ein Dichtelement eine erste Auflagefläche bereitstellt, wobei im Gehäuse eine zweite Auflagefläche bereitgestellt ist, so dass die Dichtung im montierten Zustand unter Anpressdruck zwischen Verschlusselement und Gehäuse angeordnet ist, insbesondere wasserdicht abdichtet.

Weiterhin ist vorgesehen, dass innerhalb des Gehäuses eine Steuerungselektronik angeordnet ist, welche wenigstens eine Platine aufweist. Die Steuerungselektronik weist geeignete Mittel auf, um Öffnungs- und/oder Schließbefehle an ein elektronisches Schloss zu übermitteln. Insbesondere kann die Steuerungselektronik hierzu eine drahtlose Kommunikationsverbindung aufweisen. Die Platine weist elektronische Schalter auf, insbesondere kapazitive Kontakte, Mikroschalter, Piezoschalter oder dergleichen. Mittels der Platine ist eine Benutzereingabe, beispielsweise eine Ziffernfolge, in elektronische Signale wandelbar. Die Steuerungselektronik ist zum Auswerten der elektronischen Signale ausgebildet.

Gemäß einer vorteilhaften Weiterbildung der Erfindung ist zwischen dem Gehäuseunterteil und dem Deckel und/oder zwischen dem Verschlusselement und der Ausnehmung eine semipermeable Membran angeordnet. Die semipermeable Membran ermöglicht in einer Durchlassrichtung einen Feuchtigkeitstransfer, dichtet in der anderen Richtung jedoch gegenüber Feuchtigkeit ab. Die semipermeable Membran ist derart angeordnet, so dass Feuchtigkeit aus dem Gehäuse austreten kann, Feuchtigkeit von außerhalb des Gehäuses jedoch nicht in das Gehäuse eindringen kann. In vorteilhafter Weise dichtet die semipermeable Membran das Gehäuse nach außen wasserdicht ab, und ermöglicht gleichzeitig den Austritt von Feuchtigkeit, insbesondere Kondensfeuchtigkeit, aus dem Gehäuse.

Gemäß einer vorteilhaften Weiterbildung der Erfindung weist der Deckel eine Tastatur mit Tastfeldern auf, wobei die Tastfelder mit korrespondierenden Bereichen auf der Platine zusammenwirken und einstückig mit dem Deckel ausgebildet sind. Erfindungsgemäß sind dabei die Tastfelder einstückig mit dem Deckel ausgebildet. In vorteilhafter Weise ist der Deckel wasserdicht ausgebildet, da keine Fugen, Klebstellen oder dergleichen zur Verbindung der Tastfelder vorgesehen sind. Die Tastfelder wirken mit korrespondieren Bereichen auf der Platine zusammen, insbesondere mit den elektronischen Schaltern. Mittels Drückens auf ein Tastfeld ist ein elektronisches Signal auf der Platine auslösbar.

Gemäß einer vorteilhaften Weiterbildung der Erfindung ist die Platine lagegenau in Abhängigkeit der Tastfelder federelastisch gelagert, wobei eine Federelastizität derart vorgesehen ist, dass Fertigungstoleranzen und/oder unterschiedliche Wärmeausdehnungen der Materialien durch Witterungs- und/oder elektrische Einflüsse ausgleichbar sind. Die Platine kann dabei mittels Auflagern im Gehäuse gelagert sein, Insbesondere kann die Platine dabei unter Zwischenordnung von jeweils einem federelastischen Element in jedem Auflager mittels der Auflager im Gehäuse gelagert sein. Die federelastischen Elemente können insbesondere durch Gummidichtungen, Federn oder dergleichen gebildet sein. Die Platine liegt somit unter Vorspannung an der Deckelunterseite an. Die zwischen Deckel und Platine wirkende Kraft ist dabei auch bei Störkräften, unterschiedlichen Wärmeausdehnungen der Materialen durch Witterungs-und/oder elektrische Einflüsse, durch Fertigungstoleranzen und/oder dergleichen im Wesentlichen konstant. In vorteilhafter Weise werden Fehlauslösungen der elektronischen Schalter der Platine verhindert. Gleichzeitig ist die Steuereinrichtung in einem weiten Temperatur- und/oder Luftfeuchtigkeitsbereich betreibbar, da sich aufgrund von Wärmeentwicklung durch die elektronischen Bauteile innerhalb des Gehäuses, und Wärmeeinwirkungen von außen Deckel und Platine unterschiedliche ausdehnen können, dabei jedoch die federelastische Lagerung der Platine unter Vorspannung den Ausgleich dieser unterschiedlichen Wärmeausdehnungen gewährleistet.

Gemäß einer vorteilhaften Weiterbildung der Erfindung sind die Tastfelder durch Vertiefungen und/oder Erhöhungen im Deckel gebildet, die vorzugsweise eine gegenüber dem nicht als Tastfelder ausgebildeten Bereichen des Deckels geringere Materialstärke aufweisen. Dabei kann vorgesehen sein, dass die den Tastfeldern abgewandte Seite des Deckels eben ausgebildet ist, und die Tastfelder durch Vertiefungen auf der anderen Seite des Deckels gebildet sind. Der Deckel kann dabei im Bereich der Tastfelder mit der den Tastfeldern abgewandten Seite unmittelbar mit der Platine zusammenwirken. Es kann aber auch vorgesehen sein, dass die Tastfelder durch Erhöhungen im Deckel gebildet sind. Dabei kann vorgesehen sein, dass zwischen Erhöhung und Platine geeignete Übertragungsmittel, beispielsweise Stößel, vorgesehen sind, um ein Drücken des Tastfelds durch einen Benutzers auf die Platine zu übertragen. Die Materialstärke des Deckels kann dabei eine Dicke von 2 mm bis 8 mm aufweisen. Die als Tastfelder ausgebildeten Bereiche des Deckels weisen bevorzugt eine Materialstärke mit einer Dicke von 0,5 mm bis 3,0 mm auf. Somit bilden die Tastfelder Bereiche auf dem Deckel, die sich im Vergleich zu den nicht als Tastfelder ausgebildeten Bereichen des Deckels einfach auslenken lassen. In vorteilhafter Weise ermöglicht die Ausbildung der Tastfelder die einstückige, und damit dauerhaft wasserdichte Ausbildung von Tastfeldern und Deckel bei einer gleichzeitig zuverlässigeren und verbesserten Handhabung der Steuereinrichtung.

Gemäß einer vorteilhaften Weiterbildung der Erfindung weist jedes Tastfeld eine sich an den Umfang des Tastfeldes anschließende Tasche auf, welche der Aufnahme von Flüssigkeit, insbesondere Regenwasser dient. Die Tasche kann dabei durch eine im Vergleich zum Tastfeld geringere Vertiefung gebildet sein. Insbesondere kann vorgesehen sein, dass eine Tasche sich sowohl an den Umfang eines Tastfeldes, als auch an den Umfang eines benachbarten Tastfeldes anschließt. Die Tastfelder bilden dabei mittels der Taschen eine Art Kanalsystem, welches dem Abfließen von Flüssigkeit, insbesondere Regenwasser, vom Deckel dient. In vorteilhafter Weise kann das Tastfeld weitestgehend von Flüssigkeit freigehalten werden. Versuche der Anmelderin haben nämlich gezeigt, dass Flüssigkeit, die sich in den Vertiefungen der Tastfelder ansammelt, bereits eine solche Gewichtskraft auf ein Tastfeld ausüben kann, so dass ein Fehlauslösen der Steuereinrichtung möglich ist. Mittels der erfindungsgemäßen Taschen, die sich an den Umfang der Tastfelder anschließen, wird eine Ansammlung von Flüssigkeit im Tastfeld frühzeitig abgeführt, was ein Ansammeln einer kritischen Flüssigkeitsmenge in einem Tastfeld, welche ein fehlerhaftes Auslösen bewirken könnte, wirksam unterbindet.

Gemäß einer vorteilhaften Weiterbildung der Erfindung besteht der Deckel aus einem transparenten oder transluzenten Kunststoff, der auf seiner dem Gehäuseunterteil zugewandten Oberfläche bedruckt ausgebildet ist. Es kann aber auch vorgesehen sein, dass der Deckel auf seiner dem Gehäuseunterteil zugewandten Oberfläche mit einer bedruckbaren Folie ausgebildet ist. Der Deckel ist also aus einem transparenten oder transluzenten Grundkörper gebildet, welcher eine Durchsicht, insbesondere auf hinter dem Deckel angeordnete Bezeichnungen oder Anzeigen ermöglicht. Alternativ und/oder zusätzlich kann auf der dem Gehäuseunterteil zugewandten Oberfläche des Deckels eine bedruckbare Folie angeordnet, insbesondere verklebt sein. Der transparente oder transluzente Grundkörper kann somit mit einer für den individuellen Anwendungsfall spezifisch ausgestalteten bedruckbaren Folie versehen sein. Auf der bedruckbaren Folie können insbesondere Symbole, wie beispielsweise Ziffern oder Buchstaben aufgedruckt sein, welche in zu den Tastfeldern des Deckels korrespondierenden Bereichen angeordnet sind. Dabei kann insbesondere vorgesehen sein, dass die Symbole voll aufgedruckt sind, so dass der das Symbol umgebende Bereich hinterleuchtbar ist. Es kann aber auch vorgesehen sein, dass der das Symbol umgebende Bereich aufgedruckt ist, und das Symbol selbst mittels Hinterleuchtung sichtbar ist. Im montierten Zustand weisen die Tastfelder somit eine durch einen Nutzer sichtbare Beschriftung auf. Weiterhin kann vorgesehen sein, dass die bedruckbare Folie eine Grundfarbe aufweist, die im endmontierten Zustand eine Durchsicht von außen in das Gehäuse unmöglich macht. Weiterhin kann vorgesehen sein, dass bestimmte Bereiche der bedruckbaren Folie transparent oder transluzent ausgebildet sind, so dass innerhalb des Gehäuses angeordnete optische Anzeigeelemente von außen sichtbar sind. Die Tastfelder können dabei durch gekennzeichnete Bereiche auf der Tastatur gebildet sein, insbesondere durch aufgedruckte Ziffern, so dass ein Benutzer mittels der Tastfelder beispielsweise eine Ziffernkombination an der Steuereinrichtung eingeben kann.

Gemäß einer vorteilhaften Weiterbildung der Erfindung ist zwischen der Platine und dem Deckel ein Lichtleiter ausgebildet. Der Lichtleiter dient der hinteren Ausleuchtung der Tastfelder. Dabei kann vorgesehen sein, dass sämtliche Tastfelder der Steuereinrichtung ausgeleuchtet werden. Insbesondere kann auch vorgesehen sein, dass beim Drücken eines Tastfeldes das jeweilige Tastfeld beleuchtet wird, so dass eine optische Rückmeldung für einen Nutzer gegeben ist. Insbesondere kann der Lichtleiter eine Dicke von 0,3 mm bis 2,0 mm aufweisen. gebildet sein. Als besonders vorteilhaft hat es sich herausgestellt, wenn der Lichtleiter eine Dicke von 0,7 mm aufweist, und der Deckel im Bereich der Tastfelder ebenfalls eine Dicke von 0,7 mm aufweist.

Gemäß einer vorteilhaften Weiterbildung der Erfindung weist die Steuereinrichtung eine Anzeigevorrichtung auf, beispielsweise ein Display, welches in dem Gehäuse angeordnet ist und mit einem transparenten oder transluzenten Bereich des Deckels zusammenwirkt. Es kann dabei ein LCD-, CRT-, LED-Display oder dergleichen vorgesehen sein. Insbesondere umfasst die Anzeigevorrichtung einzelne LEDs, welche auch durch verschiedenfarbige LEDs gebildet sein können. Im Bereich der bedruckbaren Folie kann ein mit der Anzeigevorrichtung korrespondierender Bereich ausgenommen sein, so dass die Anzeigevorrichtung, insbesondere das Display, von außen durch den Deckel einsehbar ist. Dabei ist der zum Display korrespondierende transparente oder transluzente Bereich einstückig mit dem Deckel ausgebildet, so dass das Display wasserdicht innerhalb des Gehäuses angeordnet ist.

Weitere Vorteile und Merkmale der Erfindung ergeben sich aus der nachfolgenden Figurenbeschreibung. Dabei zeigen:
- Figur 1: Steuereinrichtung mit einzelnen Komponenten in Explosivdarstellung,
- Figur 2: perspektivische Ansicht der Steuereinrichtung im endmontierten Zustand, und

- Figur 3: perspektivische Seitenansicht der Steuereinrichtung im endmontierten Zustand.

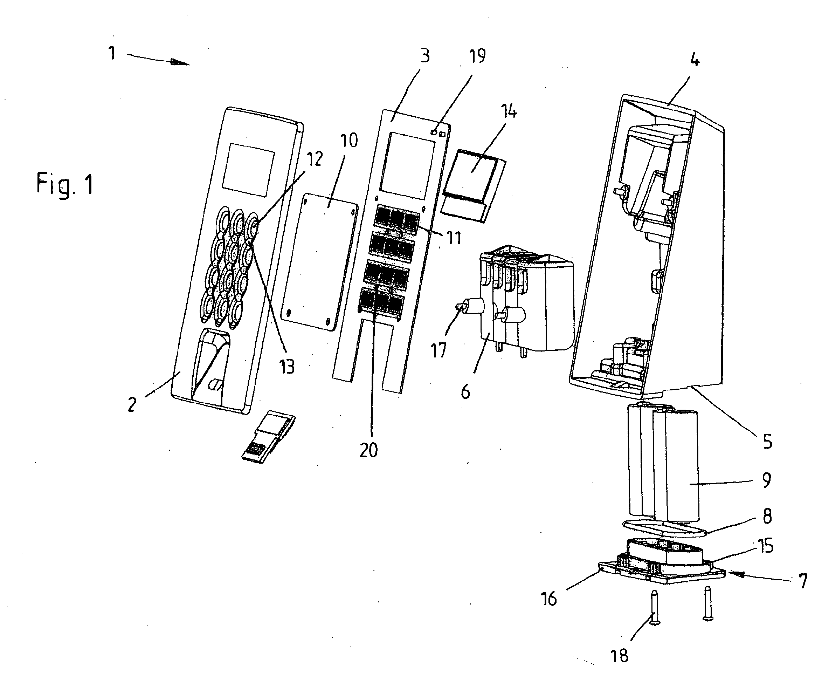

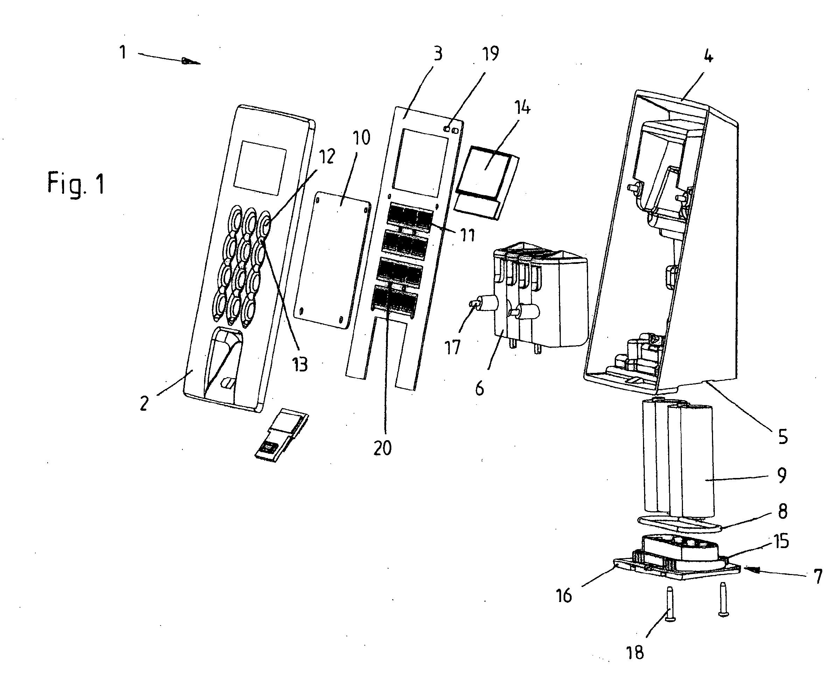

Die Figur 1 zeigt in Explosivdarstellung die erfindungsgemäße Steuereinrichtung mit wesentlichen Komponenten. Die Steuereinrichtung umfasst ein Gehäuse 1, welches aus einem Deckel 2 und einem Gehäuseunterteil 4 besteht. Das Gehäuseunterteil 4 ist durch einen schalenförmigen Körper aus Kunststoff gebildet. Der Deckel 2 ist durch eine das Gehäuseunterteil 4 abdeckendes Element aus Kunststoff gebildet. Das Gehäuseunterteil weist eine Öffnung 5 auf, durch welche eine Energiequelle zugänglich ist. Die Energiequelle umfasst eine Batteriebox 6, sowie daran anzuordnende Batterien 9. Die Öffnung 5 des Gehäuseunterteils 4 ist mittels eines Verschlusselements 7 verschließbar.
Das Verschlusselement 7 weist einen Kragen 15 auf, welcher eine einsteckseitige Schulter zum Anlegen einer Dichtung 8 bereitstellt. Der Deckel 7 ist aus Kunststoff gebildet. Der Deckel 7 weist ferner als Greifmittel einen angefasten Flansch 16 auf, welcher die Handhabung des Deckels 7 für einen Nutzer erleichtert.

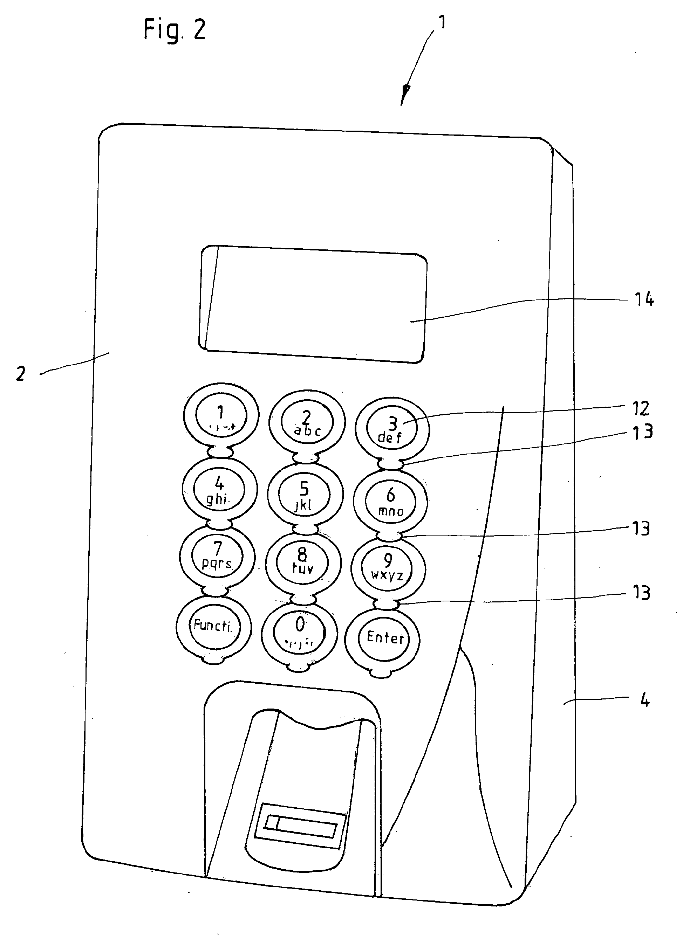

Figur 2 zeigt die erfindungsgemäße Steuereinrichtung im montierten Zustand in perspektivischer Darstellung. Der Deckel 2 ist mit dem Gehäuseunterteil 4 wasserdicht verbunden. Vorliegend ist der Deckel 2 mit dem Gehäuseunterteil 4 durch Ultraschallschweißung verbunden. Dies bewirkt einerseits, dass die aus Kunststoff gebildeten Bauteile Deckel 2 und Gehäuseunterteil 4 wasserdicht miteinander verbunden sind, und andererseits der Deckel 2 nicht zerstörungsfrei vom Gehäuseunterteil 4 lösbar ist. Bei einer Zerstörung des Gehäuses 1 können entsprechende Maßnahmen, beispielsweise eine Türverriegelung oder ―öffnung eingeleitet werden. Dies dient insbesondere der verbesserten Sicherheit der Steuereinrichtung.

Weiterhin ist zwischen Deckel 2 und Gehäuseunterteil 4 eine semipermeable Membran angeordnet. Die semipermeable Membran ist derart angeordnet, so dass sie in Richtung vom Gehäuseinneren nach außen für Flüssigkeit durchlässig ist, und in der Gegenrichtung flüssigkeitsdicht ist.

Im Gehäuse 1 ist eine nicht dargestellte Steuerungselektronik angeordnet, welche eine Platine 3 umfasst. Wie in Figur 1 dargestellt, weist die Platine 3 elektronische Schalter 11 auf, welche eine mechanische Eingabe eines Benutzers in ein elektrisches Signal umwandeln. Die nicht dargestellte Steuerungselektronik weist dabei geeignete Mittel auf, beispielsweise eine drahtlose Kommunikationsverbindung, mittels welcher durch Eingaben des Nutzers ausgelöste Öffnungs- und/oder Schließbefehle an ein elektronisches Schloss übermittelbar sind. Die elektronischen Schalter 11 auf der Platine 3 sind korrespondierend zu auf dem Deckel 2 vorgesehenen Tastfeldern 12 angeordnet. Die Tastfelder 12 im Deckel 2 sind durch halbkugelartige Vertiefungen gebildet. In den Bereichen der Tastfelder 12 weist der Deckel 2 eine geringere Materialstärke auf, als in den nicht als Tastfelder 12 ausgebildeten Bereichen. Im montierten Zustand wird ein auf die dem Gehäuseinneren abgewandte Seite des Deckels ausgeübter Druck auf ein Tastfeld 12 auf den jeweils zum Tastfeld 12 korrespondierenden elektronischen Schalter 11 der Platine 3 übertragen. Insofern ist es möglich, mittels der Tastfelder 12, welche beispielsweise die Ziffern 0 bis 9 abstrahieren, eine Ziffernfolge an die Steuereinrichtung zu übermitteln.

Die Tastfelder 12 sind einstückig mit dem Deckel 2 ausgebildet. An den Umfang jedes Tastfelds 12 schließt sich eine Tasche an, welche der Aufnahme von Flüssigkeit, insbesondere Regenwasser dient. Insbesondere sind die Taschen von in Längsrichtung der Steuereinrichtung benachbarten Tastfeldern 12 sowohl an den Umfang des einen Tastfeldes, als auch an den Umfang des benachbarten Tastfeldes angeschlossen. Feuchtigkeit wird somit in Gravitationsrichtung von den Tastfeldern weg abgeleitet. Die Taschen 13 sind dabei als Vertiefungen ausgebildet, sind jedoch weniger tief als die Tastfelder 12 ausgebildet.

Die Platine 3 ist mittels Auflagern im Gehäuse gelagert. Zwischen Platine 3 und Auflagern 17 sind Federelemente vorgesehen. Im montierten Zustand halten die Federelemente die Platine 3 unter einer definierten Vorspannung gegen die Rückseite des Deckels 2 gedrückt. Zwischen Platine 3 und Deckel 2 ist ein Lichtleiter 10 vorgesehen. Der Lichtleiter 10 beleuchtet die Tastfelder 12 des Deckels 2 rückseitig. Insbesondere kann auch vorgesehen sein, dass der Lichtleiter 10 ein jeweiliges Tastfeld 12 beim Drücken des Tastfelds 12 rückseitig entsprechend beleuchtet. Die Position von Platine 3 und Lichtleiter 10 ist in der Deckelebene relativ zum Deckel 2 festgelegt. Dazu dienen die Auflagerelemente 17. Diese lagern sowohl Platine 3, Lichtleiter 10 als auch Deckel 14 in der Deckelebene.

Der Deckel 2 ist aus einem transparenten oder transluzenten Kunststoff gebildet, welcher Kunststoff an der dem Gehäuseinneren zugewandten Seite mit einer bedruckbaren Folie verbunden, insbesondere verklebt ist. Die bedruckbare Folie weist dabei im vorliegenden Ausführungsbeispiel eine weiße Grundfarbe auf. In den zu den Tastfeldern 12 des Deckels 2 korrespondierenden Bereichen ist die Folie mit Ziffern und/oder Buchstaben bedruckt. Ein Nutzer kann so in intuitiver Weise die verschiedenen Tastfelder 12 bestimmten Funktionen zuordnen. Im Bereich eines Displays 14 ist ein nicht bedruckter Bereich auf der Folie vorgesehen. Ein Nutzer kann somit durch den transparenten oder transluzenten Kunststoff hindurch das Display ablesen. Neben dem Display 14 können andere und/oder zusätzliche Anzeigeelemente vorgesehen sein, insbesondere akustische Anzeigen wie beispielsweise einen Schallgeber. Im gezeigten Ausführungsbeispiel sind auf der Platine 3 LEDs 20 vorgesehen, welche mit korrespondierenden transparenten oder transluzenten Bereichen des Deckels 2 zusammenwirken.

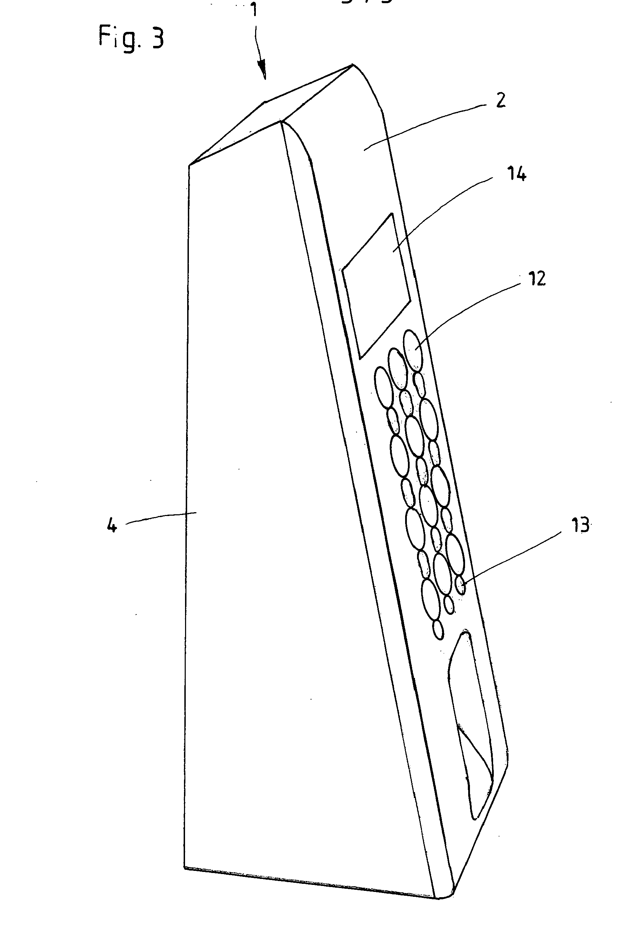

Figur 3 zeigt die montierte Steuereinrichtung in einer perspektivischen Seitenansicht. Bodenfläche des Gehäuseunterteils und Deckelfläche sind antiparallel zueinander. Das Gehäuse hat in der Seitenansicht eine trapezförmige Geometrie.

Figur 1 zeigt weiterhin Befestigungsmittel 18, insbesondere Schrauben, mittels welcher das Verschlusselement 7 am Gehäuseunterteil 4 befestigt ist.

Weiterhin weist die Platine 3 einen Lichtsensor 19, insbesondere Fotowiderstand, auf, welcher die Helligkeit am Einsatzort erfasst. In Abhängigkeit der Helligkeit am Einsatzort ist die Hinterleuchtung der Tastfelder 12 mittels des Lichtleiters 10 einstellbar. Insbesondere ist die Hinterleuchtung der Tastfelder 12 ab einem Schwellwert der Helligkeit einschaltbar. In vorteilhafter Weise kann bei ausreichender Helligkeit der Umgebung Energie durch ein Herunterregeln und/oder Abschalten der Hinterleuchtung eingespart werden.

Die Herstellung der erfindungsgemäßen Steuereinrichtung geht wie folgt von statten. Ein Gehäuseunterteil 4 wird mit einem Deckel 2 wasserdicht verbunden, insbesondere durch Ultraschallverschweißung. Eine Ausnehmung, insbesondere eine Öffnung 5 im Gehäuse zum Zugang einer in dem Gehäuse 1 angeordneten Energiequelle wird mittels eines Verschlusselements 7 gegen das Eindringen von Feuchtigkeit, insbesondere Regenwasser, abgedichtet, insbesondere wasserdicht abgedichtet. Hierzu wird an dem Verschlusselement 7 ein Kragen 15 ausgebildet, welcher eine einsteckseitige Schulter zum Anlegen einer Dichtung 8 bereitstellt. Ferner wird zwischen dem Gehäuseunterteil 4 und dem Deckel 2 und/oder zwischen dem Verschlusselement 7 und der Ausnehmung 5 eine semipermeable Membran angeordnet. In dem Gehäuse 1 wird eine Platine 3 angeordnet. Die Platine 3 wird derart angeordnet, so dass auf der Platine 3 vorgesehene elektronische Schalter 11 mit Tastfeldern 12 des Deckels 2 zusammenwirken. Die Platine 3 wird ferner mittels Federelementen unter Vorspannung gegen die Deckelrückseite gedrückt. Hierzu werden zwischen Auflagern 17 und Platine 3 Federelemente angeordnet. Die Tastfelder 12 auf dem Deckel 2 werden durch Erhöhungen und/oder Vertiefungen gebildet. Der Deckel 2 wird dabei beispielsweise mittels eines Spritzgussverfahrens hergestellt, wobei die Bereiche des Deckels 2 die nicht als Tastfelder 12 ausgebildet sind, eine höhere Materialstärke aufweisen.

Ferner wird an jedem Tastfeld 12 eine sich an den Umfang des Tastfeldes 12 anschließende Tasche 13 gebildet, welche der Aufnahme von Flüssigkeit, insbesondere Regenwasser dient.

Der Deckel 2 wird ferner aus einem transparenten oder transluzenten Kunststoff gebildet, der auf seiner dem Gehäuseunterteil 4 zugewandten Oberfläche mit einer bedruckbaren Folie verbunden wird.

Zwischen Platine 3 und Deckel 2 wird ferner ein Lichtleiter 10 angeordnet.

In dem Gehäuse 1 wird eine Anzeigevorrichtung, beispielsweise ein Display 14 angeordnet und zum Zusammenwirken mit einem transparenten oder transluzenten Bereich des Deckels 2 ausgebildet.

Die Materialdicke des Deckels 2 wird derart gewählt, so dass bei Verformungen aufgrund von Temperaturschwankungen ein Fehlkontakt mit der Platine 3 unterbunden wird.

Bezugszeichen:
- 1: Gehäuse
- 2: Deckel
- 3: Platine
- 4: Gehäuseunterteil
- 5: Öffnung
- 6: Batteriebox
- 7: Verschlusselement
- 8: Dichtung
- 9: Energiequelle
- 10: Lichtleiter
- 11: elektronischer Schalter
- 12: Tastfeld
- 13: Tasche
- 14: Display
- 15: Kragen
- 16: angefaster Flansch
- 17: Auflager
- 18: Befestigungsmittel
- 19: Lichtsensor
- 20: LED

## Patentansprüche

1. Steuereinrichtung zur Steuerung, insbesondere zur Übermittlung von Öffnungs-und/oder Schließbefehlen eines elektronischen Schlosses, mit einer in einem Gehäuse (1) angeordneten, mindestens eine Platine (3) aufweisenden Steuerungselektronik, welches Gehäuse (1) aus einem Gehäuseunterteil (4) und einem Deckel (2) besteht, wobei Gehäuseunterteil (4) und Deckel (2) aus Kunststoff ausgebildet sind, und wobei Gehäuseunterteil (4) und Deckel (2) derart wasserdicht miteinander, insbesondere durch Ultraschallverschweißung, verbunden sind, dass das Gehäuseunterteil (4) und der Deckel (2) nicht ohne Zerstörung voneinander lösbar sind.

2. Steuereinrichtung nach Anspruch 1, **dadurch gekennzeichnet, dass** das Gehäuse (1) eine Ausnehmung, insbesondere eine Öffnung aufweist, durch welche eine in dem Gehäuse (1) angeordnete Energiequelle (9) zugänglich ist, wobei die Ausnehmung, insbesondere die Öffnung, mittels eines Verschlusselements (7) gegen das Eindringen von Feuchtigkeit, insbesondere Regenwasser, abgedichtet ist.

3. Steuereinrichtung nach Anspruch 2, **dadurch gekennzeichnet, dass** zwischen dem Gehäuseunterteil (4) und dem Deckel (2) und/oder zwischen dem Verschlusselement (7) und der Ausnehmung eine semipermeable Membran angeordnet ist.

4. Steuereinrichtung nach einem der vorangehenden Ansprüche, **dadurch gekennzeichnet, dass** der Deckel (2) eine Tastatur mit Tastfeldern (12) aufweist, wobei die Tastfelder (12) mit korrespondierenden Bereichen auf der Platine (3) zusammenwirken und einstückig mit dem Deckel (2) ausgebildet sind.

5. Steuereinrichtung nach einem der vorangehenden Ansprüche, **dadurch gekennzeichnet, dass** die Platine (3) lagegenau in Abhängigkeit der Tastfelder (12) federelastisch gelagert ist, wobei eine Federelastizität derart vorgesehen ist, dass Fertigungstoleranzen und/oder unterschiedliche Wärmeausdehnungen der Materialien durch Witterungs- und/oder elektrische Einflüsse ausgleichbar sind.

6. Steuereinrichtung nach Anspruch 4, **dadurch gekennzeichnet, dass** die Tastfelder (12) durch Vertiefungen und/oder Erhöhungen im Deckel (2) gebildet sind, die vorzugsweise eine gegenüber den nicht als Tastfelder (12) ausgebildeten Bereichen des Deckels (2) geringere Materialstärke aufweisen.

7. Steuereinrichtung nach Anspruch 4, **dadurch gekennzeichnet, dass** jedes Tastfeld (12) eine sich an den Umfang des Tastfeldes (12) anschließende Tasche (13) aufweist, welche der Aufnahme von Flüssigkeit, insbesondere Regenwasser dient.

8. Steuereinrichtung nach einem der vorangehenden Ansprüche, **dadurch gekennzeichnet, dass** der Deckel (2) aus einem transparenten oder transluzenten Kunststoff besteht, der auf seiner dem Gehäuseunterteil (4) zugewandten Oberfläche mit einer bedruckbaren Folie ausgebildet ist.

9. Steuereinrichtung nach einem der vorangehenden Ansprüche, **dadurch gekennzeichnet, dass** zwischen der Platine (3) und dem Deckel (2) ein Lichtleiter (10) ausgebildet ist.

10. Steuereinrichtung nach einem der vorangehenden Ansprüche, **gekennzeichnet durch** eine Anzeigevorrichtung, beispielsweise ein Display (14), die in dem Gehäuse (1) angeordnet ist und mit einem transparenten oder transluzenten Bereich des Deckels (2) zusammenwirkt.

11. Steuereinrichtung nach Anspruch 10, **dadurch gekennzeichnet, dass** der transparente oder transluzente Bereich des Deckels (2) für das Display (14) mit dem übrigen Teil des Deckels (2) einstückig ausgebildet ist.
